# EUROPEAN PATENT SPECIFICATION

(11) **EP 2 605 346 B1**
(45) Date of publication and mention of the grant of the patent: **23.08.2017**
(21) Application number: 11009831.6
(22) Date of filing: 14.12.2011
(51) Int. Cl.: H01S 5/16, H01S 5/10

(54) **Diode type laser device**
Laserdiode
Diode laser

(43) Date of publication of application: 19.06.2013
(73) Proprietor: Petrescu-Prahova, Iulian Basarab, Trenton, NJ 08611 (US)
(72) Inventor: Petrescu-Prahova, Iulian Basarab, Trenton, NJ 08611 (US)
(74) Representative: Grättinger, Günter

(56) References cited:
- WO-A1-98/57401
- JP-A- 2008 034 663
- US-A- 5 444 730
- US-A1- 2004 190 575
- US-A1- 2007 165 685
- US-A1- 2008 259 982
- US-A1- 2011 317 730
- LEE J J ET AL: "Asymmetric Broad Waveguide Diode Lasers (<maths><tex>$\lambda = 980$</tex></maths> nm) of Large Equivalent Transverse Spot Size and Low Temperature Sensitivity", IEEE PHOTONICS TECHNOLOGY LETTERS, IEEE SERVICE CENTER, PISCATAWAY, NJ, US, vol. 14, no. 8, 1 August 2002 (2002-08-01) , XP011067237, ISSN: 1041-1135

## Description

### TECHNICAL FIELD

The present invention relates to diode laser type of devices comprising: a first, initial layered structure made of semiconductor materials with selected optical properties that comprise two optical waveguides, one waveguide, which includes an active region and another waveguide, which captures part of the radiation emitted in the active region, and two cladding layers that transversally confine the emitted radiation in the layered structure whereas, a less absorbing window is formed in a second layered structure by removing part of the top cladding layer such that the emitted radiation is shifted toward the trapping waveguide and the confinement factor is reduced.

### BACKGROUND

Laser oscillators and laser amplifiers are most known diode type laser devices, in short diode laser devices. This application is related to edge emitter diode lasers, wherein the amplification by stimulated emission (laser effect) is produced along a device which is millimeters long and the emission exits through facets at the ends of the device. It is known that the active region projection on the exit facets is the element of diode type laser devices which is most sensitive to degradation. This is the place where Catastrophic Optical Degradation (COD) and important gradual degradation processes occur. These degradation processes represent important factors that limit the operation of these lasers at high power and at high power density of the radiation that traverse the exit window. The catastrophic degradation is practically instantaneous when the power density of the radiation, emitted through the active region at the mirror facet, overpasses certain threshold values. The values for the power density of the emitted radiation that passes through the active region and produce catastrophic degradation are, in a great extent, material characteristics. In some cases, the gradual degradation starts from the mirror, having in the end, after a period, the same effects as the catastrophic degradation, i.e. the irremediable destruction of the mirrors and of the laser. To avoid degradation, laser operation at power and power density levels lower than the catastrophic degradation level is recommendable. The catastrophic degradation is produced with the contribution of electronic states at the exit windows surface, surface states that modify the distribution of the electrical potential and the light absorption phenomena in the superficial layer at the semiconductor material--external medium interface. To remedy the effects induced by these surface states several solutions for obtaining less sensitive "windows" for diode laser were imagined.

There are known diode lasers whereat the surface of the window facet of diode lasers, defined as the interface between the semiconductor material of the type A₃B₅, A₂B₆, or other semiconductor materials and the external medium, most frequently the surrounding air, is covered with thin layers of other materials. There are such proposals for mirror covering with different types of oxides, including the natural oxides of the semiconductor materials of the laser structure. The disadvantage of the oxide covering is that usually they do not produce the highest catastrophic degradation power levels. There are proposals for mirror covering with other semiconductor materials, transparent to the laser emitted radiation, for example with ZnSe, usually polycrystalline. Although it produces a very high catastrophic degradation level, the disadvantage of this method is that, in order to have the highest efficiency and reliability, the deposition of other semiconductor materials need to be done in very clean conditions, for example by cleaving the mirrors in very high vacuum and by immediately covering the resulting facet in this high vacuum conditions.

There are also known diode lasers whereat the mirror facet is covered with semiconductor materials from the same family as the semiconductor materials that form the multilayer structure of the diode laser, for example a material of the type AlₓGa₁₋ₓAs in the case of a structure obtained from layers in the AlₓGa₁₋ₓAs system. In all cases the covering material has the energy gap higher than the energy gap of the active layer, in order to be transparent to the laser emitted radiation. To deposit this covering semiconductor material, in the semiconductor wafer that contains a laser layered structure, narrow etching streets are formed at the approximate location where the future mirror will be and the new covering material is deposited in place of the etched material. The disadvantage of this method is that in order to etch the active region and to replace it with other semiconductor material, the entire waveguide is affected and the waveguide is interrupted at the etch-regrowth interface, at a certain distance from the exit window surface. This is especially true for symmetric layered structures that contain the active region in the middle of the structure's single waveguide. From the etch-regrowth interface the radiation propagates toward the facet by diffraction. A wide etching street has the disadvantage that increases the diffraction losses and reduces the effective reflection coefficient. A narrow etching stripe, with a pronounced depth profile, has the disadvantage that is more difficult to be obtained in real life, the regrowth processes are more difficult and the further cleaving inside of a narrow stripe is more difficult.

There are known diode laser structures that comprise two waveguides where the active region is located asymmetrically relative to the whole structure. In this case only one waveguide is etched and the full etch-regrowth process can reconstruct a waveguide with similar properties as the initial waveguide, but still have the disadvantage they are formed by a difficult process.

WO98/57401 discloses a diode type laser with a window structure which comprises a first segment and a second segment having a modified layered structure adjacent to an output window. In the first segment there is provided, on a substrate, a bottom confinement layer, a waveguide layer, a separation layer, an active layer and a top confinement layer. The active layer is situated asymmetrically relative to the central region of the waveguide, closer to a top contact layer. To form the windows, the asymmetrical structure is partially etched, whereby the top confinement layer and the active region are removed but the central waveguide region is preserved intact. After etching, a confinement layer is regrown, this layer being similar in properties with the previously etched confinement layer so that the overlapping coefficient of the mode in the two segments is close to unity.

Both etch-regrowth solutions have the disadvantages that the etching dissolves the active region itself, possibly leaving, at the interface between the undisolved active region and the regrown material, defects that act as nonradiative recombination centers, and that the regrowth process is by itself cumbersome.

### BRIEF SUMMARY OF THE INVENTION

The problem solved by this invention is the attainment of less absorbing windows that do not interrupt essentially the propagation properties of a diode laser type waveguide to the mirror facet, reduces the absorption losses and nonradiative recombination in a region close to the mirror facet and does not introduce supplementary defects when implemented.

This object is solved by a diode laser as defined in claim 1.

The windows for diode type laser devices according to the invention avoid the disadvantages of other known solution since:
they are obtained in first layered structures with two waveguides, one containing the active region being situated closer to the top of the layered structure and a second waveguide that captures part of the radiation emitted in the active region
wherein by removing part of the top cladding layer but not touching the active region a second layered structure is formed between the first layered structure and an exit mirror facet, part of the radiation propagating in the modified layered structure is shifted from the active waveguide toward the trapping waveguide, avoiding absorption losses and nonradiative recombination in the active region close to the mirror facet,
but by this modification a large part of the layered structure remains unaffected, such that the optical properties of the initial structure are preserved into a great extent, so that the radiation is propagating up to the mirror into a double waveguide similar to the double waveguide of the initial first layered structure of the diode type laser devices.

The diode type laser devices with less absorbing windows, according to the invention, have the following advantages:
the layered structure proper for the partial removal of some layers, without an essential change of the waveguide, are low confinement structures which can operate at very high power densities and output powers;
the removal process stops before the active region is reached, such that the active region is not exposed to the removal process that might induce defect formation that enhance nonradiative recombination;
the radiation propagation up to the mirror cleaved facet is done with minimum coupling losses relative to the rest of the initial, unmodified structure;
in the same process can be obtained both windows with proper optical properties and the ridges for the longitudinal propagation;

In the following, examples for the accomplishment of the invention will be given, in connection with FIG's. 1-5, that represent:
FIG. 1 A multilayer structure
FIG. 2 A possible variation of the refractive index for a first embodiment.
FIG. 3 A possible variation of the refractive index for a second embodiment
FIG. 4 A longitudinal arrangement comprising an initial layered structure and a modified layered structure, which represents a less absorbing mirror

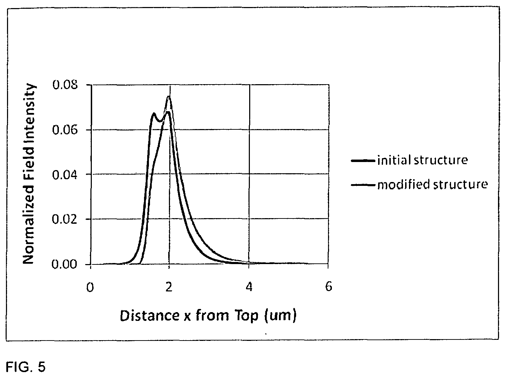

FIG. 5 Normalized intensity field distributions in transversal direction for initial and modified structures of a particular design

### DETAILED DESCRIPTION OF THE PREFERRED EMBODIMENTS

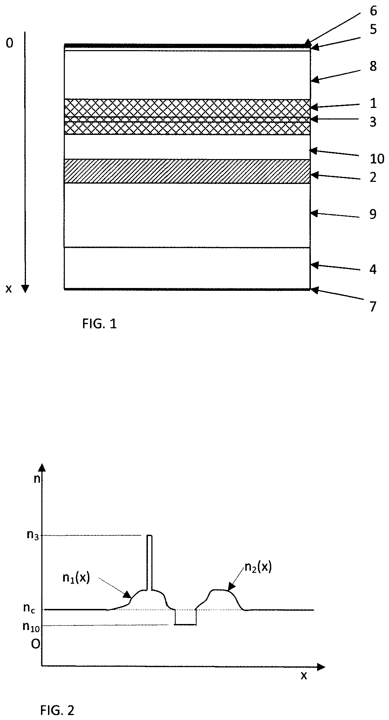

Less absorbing windows for diode type laser devices according to the invention are obtained in an initial layered structure similar to that described in FIG. 1, formed from several layers. Among these layers some form a first, active waveguide 1, double hatched in FIG. 1 and a second, trapping waveguide 2, single hatched in FIG. 1. The double waveguide comprises several other layers, also essential being two cladding layers that transversally confine the emitted radiation to the whole layered structure: a top cladding layer 8 and a substrate cladding layer 9. The two mentioned waveguides are separated by a separation layer 10. In Fig 1 is shown a structure, with a separation layer 10. The active waveguide includes at least an active layer 3. When more active layers are present they are separated by barriers for carriers and together form an active region. The active region is encompassed between a top waveguide layer 1 a and a bottom waveguide layer 1 b. The structure lays on a substrate 4 and ends with a top contact layer 5. The wording "top" is used in opposition with "substrate" which is generally accepted as being down. The radiation is produced mostly in the active region by the combination of the pairs of opposite sign charge carriers, electrons and holes, which are injected by a p-n junction located in the active region vicinity or by a p-i-n structure that includes the active region.

The active waveguide 1 that includes the active region is situated asymmetrically relative to the whole structure, closer to the top contact layer 5. The top contact layer is followed by a corresponding metal contact 6. On the other side of the substrate, relative to the multilayer structure, is situated the other metal contact 7. Using these two metal contacts 6 and 7 an electrical, bias U is applied to the structure, what produces the flow of an electrical current, I.

With reference to an orthogonal system Oxyz, the layers of the multilayer structure are parallel with the plane yOz and the radiation propagates in the longitudinal direction Oz. The Ox direction, perpendicular to the plane yOz is the transversal direction. The refractive index along the transversal direction depends on coordinate x: n = n(x). The refractive index does not depend on the lateral direction oy. The refractive indexed are named corresponding to the layer to whom they are related. The layer identification will appear as a subscript. For example if substrate cladding layer 9 has a constant refractive index, its value is n₉ and if the refractive index is variable, the function describing the variation is n₉(x).

A first embodiment is shown in FIG. 2. The refractive indexes of cladding layers have constant values n_{c}, the same for both layers: n₈ = n₉ = n_{c}. The refractive indexes in the mentioned waveguides1 and 2 are higher than the refractive indexes of the cladding layers 8 and 9. In general the waveguide's refractive indexes are variable, described by functions n₁(x) and n₂(x). The profile of the function n₁(x) and n₂(x) are bumps over the n_{c} line, which traverse the bottom of these bumps as a dashed line. The active waveguide 1 which comprises at least an active layer has at the active layers location high refractive indexes. The separation layer index n₁₀ might have values under or above this line. In case it is lower, it acts as a less transparent radiation barrier between the two waveguides. On the contrary, when is higher, it acts as a more transparent radiation barrier between the two waveguides. Bump magnitudes can characterize the waveguides.

The bump magnitudes, either that of the active waveguide 1, formed between the separation layer 10 and the top cladding layer 8, or that of the trapping waveguide 2, formed between the substrate cladding layer 9 and the separation layer 10, are defined as being equal to the sums of elementary regions thickness in these bumps δx, multiplied with the square root of the difference between the square of the refractive index of each elementary region and the square of the refractive index n₉ₘₐₓ : Σδx (n(x)²-n₉ ²). The sum of bump magnitudes needs to be relatively small for the structure with several layers to accept only the transversal fundamental mode, with the same phase in both waveguides. When the refractive index of the separation layer 10 is higher than n_{c}, its magnitude should be included in the evaluation of the sum of bump magnitudes.

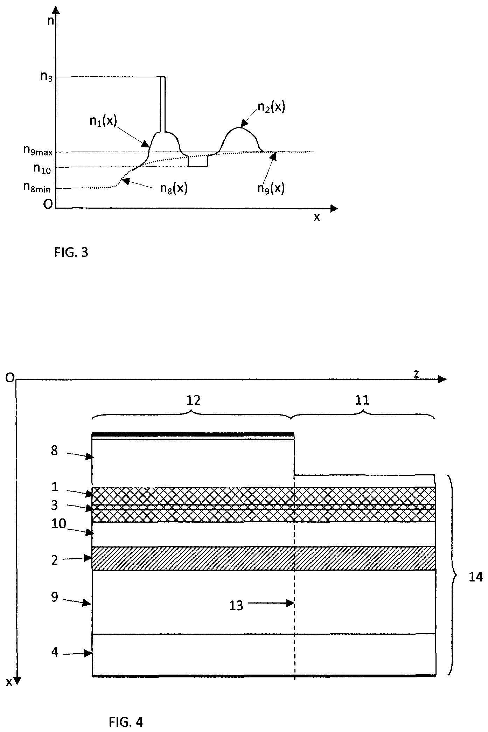

A more general embodiment is described in FIG. 3. Refractive indexes in the cladding layers 8 and 9 a function on position x. FIG. 3 shows a possible variation of the refractive index into a structure with separation layer. n₉(x) is the variable refractive index of the substrate cladding layer 9, n₉ₘₐₓ is the maximum value of the refractive index of the substrate cladding layer 9, etc. If a layer is described by a single value of its refractive index, only this value is mentioned, like n₃ or n₁₀.

To act as waveguides, the refractive indexes in the mentioned waveguides 1 and 2 should be higher than the refractive indexes of the cladding layers 8 and 9. If the refractive indexes of the cladding layers 8 and 9are functions on position x, it is preferred to have an increase of the refractive index of the cladding layers 8 and 9, from the extremity near top contact layer of the top cladding layer 8 toward the extremity near substrate of the substrate cladding layer 9 and the highest refractive index of the top cladding layer 8, n₈ₘₐₓ, is smaller or equal to the smallest refractive index of the substrate cladding layer 9, n₉ₘᵢₙ. With a dotted line is described the mentioned increasing general tendency, that is excluding the first and the second waveguide bumps and a possible variation of the separation region. In the transversal direction, the field distribution is trapped in the two mentioned waveguides 1 and 2 by the bumps formed by their refractive index profiles, relatively higher than the refractive indexes of adjacent layers. The ascending profile of function n₈(x) and n₉(x) also repels the field distribution from the cladding layer 8 and the optical first waveguide 1 toward the second waveguide 2. This effect will be named in short the optical wall effect. By using the optical wall effect, narrower top cladding layer 8 could be used to contain the radiation in the whole layered structure.

The described second structures, by a proper selection of the optical and geometrical properties of the constitutive layers, is characterized by the fact that much of the radiation field distribution is attracted toward the trapping waveguide 2 and pushed from the active waveguide 1, where the radiation is produced. The allocation of the field between these two attractors depends on the relative magnitudes of the waveguide bumps measured from the highest refractive index n₉ₘₐₓ of the substrate cladding layer 9, and on the optical wall effect that might be induced by the cladding layer 8. In comparison with the first embodiment, the position of the active waveguide and of active region closer to the top of the structure facilitates changes in field allocation by technological processes.

In the case of the second embodiment, the bump magnitudes, either that of the trapping waveguide 2, formed between the substrate cladding layer 9 and the separation layer 10, or that of the active waveguide 1, formed between the separation layer 10 and the cladding layer 8, are defined as being equal to the sums of elementary regions thickness in these bumps δx, multiplied with the square root of the difference between the square of the refractive index of each elementary region and the square of the refractive index n₉ₘₐₓ: Σδx (n²-n₉ₘₐₓ²). The sum of the bump magnitudes need to be relative small for the structure with several layers to accept only the transversal fundamental mode, with the same phase in both waveguides.

A less absorbing window structure 11 is obtained by modifying the initial structure, in a street perpendicular to the propagation direction Oz as shown in FIG. 4. By this modification, part of the cladding layer 8 is removed but the two waveguides 1 and 2, and especially the active region, are preserved intact.

As a consequence of the processes, along the propagation direction Oz in the diode laser there are two segments with two waveguide structures, an initial structure of a main segment 12 and the modified structure of an end segment 11. These two structures are separated from each other by a separation interface 13, shown with a dashed line. The modified structure is separated from the external medium by an exit facet 14.

For the initial structures with planar layers of segment 12, that are not delimited or modified in the lateral direction Oy, the modes that propagate along the propagation direction Oz are characterized by a radiation field distribution in the transversal direction Ox, a distribution described by a function E(x). In the direction Oy the E(x) function is assumed constant. The mode propagating in the modified structure of segment 11 has a radiation field distribution function E'(x). The functions E(x) and E'(x) are normalized scalar functions intended to describe the distributions of the vector electromagnetic fields E, H. They are solutions to the corresponding Helmholtz equations in the structures refractive indexes profiles. The effective refractive indexes for modes propagating in the two structures of segments 12 and 11 and noted n_{eff} and n'_{eff} are part of the same solutions.

Generally, the field distributions have maxima at the location of the two waveguides. When one of the maxima is much higher than the other one, the second maximum appears only as a shoulder to the first maximum. The relative magnitude of these maxima depends on the magnitude of the respective waveguides but also on the external condition in cladding layers. The field distribution E(x) exponentially decays inside the thickness of the cladding layer 8. Because removing part of the cladding layer 8, a second wall is approaching the active waveguide 1, the optical field trapped in this first waveguide will be pushed toward the second waveguide. Compared with the field distribution E(x) in the initial structure, the field distribution E'(x) in the modified structure 11 has an increased maximum located at the trapping waveguide and a decreased maximum located at the active waveguide. This second optical wall effect is induced by reflection on top interface 15 with the external medium: air, dielectrics, and metals depending on adopted technology.

Due the change in the relative magnitude of the two maxima, the modified structure of segment 11 has a lower confinement factor ┌' than the confinement factor r of the initial structure of segment 12. From the total flux Φ, only a fraction ┌Φ, respectively ┌'Φ, is passing through the active region. The consequence is that, as radiation travels in the modified structure of segment 11 toward the exit, a smaller flux, ┌'Φ, compared with ┌Φ, will have a chance to be absorbed near the exit facet 14 when exiting through the active region. It is known that Catastrophic Optical Degradation (COD) is mainly produced by the absorption of the radiation that exit through the active region followed by nonradiative recombination of the generated carriers. For structures with lower confinement factor the level of Catastrophic Optical Degradation is lower and the rate of gradual degradation due to changes in mirror structure is lower. The less absorbing structure of segment 11 having a lower confinement factor protects the initial structure of segment 12. The initial structure of segment 12 needs a higher confinement factor to assure enough modal gain for the laser effect.

This type of modified window structure 11 is named Less Absorbing Mirror (LAM), in contrast with other types of windows which are Non Absorbing Mirrors (NAM).

The asymmetrical structures according with the invention are characterized by the fact that these two distribution functions are very similar to each other. The changes in the field distributions from E(x) to E'(x) are localized mainly at the position of the active waveguide 1. A measure of the similarity degree for the distribution functions is the overlapping coefficient defined as |∫(x)E'(x)dx|², where it was considered that the distribution functions E(x) and E'(x) are normalized to unity. An overlapping coefficient close to unity assures reduced losses for the propagating modes when passing through the separation surface 14, so that the radiation propagating in the fundamental mode of the initial layered structure continues to propagate almost entirely in the fundamental mode of the modified layered structure. A second consequence of this similarity is that the effective refractive indexes have close values.

In table 1 a structure with a separation layer, obtained from materials in the AlₓGa₁₋ₓAs system for 940 nm emission is presented. The structure is defined by the layer's compositions and thicknesses. In this structure the active waveguide is formed by the active Quantum Well (QW) and two other layers on the top and the bottom of the QW, which in this particular case have constant refractive indexes. The trapping waveguide has also a constant refractive index. Other more sophisticate profiles of the refractive indexes in the waveguides are possible.

**Table 1. Layer's compositions and thicknesses for a structure with two waveguides**

| Layer name | Top cont act | Top cladd.. | 1^{st} w-g top | QW in w-g | 1^{st} w-g bottom | Separation | 2^{nd} w-g | Substr cladd. | Substr. |
|---|---|---|---|---|---|---|---|---|---|
| | | | 1^{st} waveguide | | | | 2^{nd}w-g | | |
| Layer ID | 3 | 6 | 1 | | | 10 | 2 | 7 | 4 |
| Comp. index x | 0.0 | 0.41 | 0.22 | InGaAs | 0.22 | 0.32 | 0.22 | 0.32 | 0.0 |
| Thickness (µm) | 0.2 | 1.2 | 0.137 | 0.007 | 0.072 | 0.3 | 0.22 | 3.4 | 100 |

In Table 2 a modified structure is presented. The difference between structure presented in Table 1 and structure presented in Table 2 is a thinner top cladding layer 6 which is covered with an oxide layer and the missing top contact layer.

**Table 2. Layer's compositions and thicknesses for a modified structure formed from an initial structure with double waveguide**

| Layer name | Oxid | Top cladd. | 1^{st} w-g top | QW in w-g | 1^{st} w-g bottom | Separation | 2^{nd} w-g. | Substr cladd. | Substr |
|---|---|---|---|---|---|---|---|---|---|
| | | | 1^{st} waveguide | | | | 2^{nd}w-g. | | |
| Layer ID | 5 | 6 | 1 | | | 10 | 2 | 7 | 4 |
| Comp. index x | 0.2 | 0.41 | 0.22 | InGaAs | 0.22 | 0.32 | 0.22 | 0.32 | 0.0 |
| Thickness (µm) | 0.2 | 0.1 | 0.137 | 0.007 | 0.072 | 0.3 | 0.22 | 3.4 | 100 |

The normalized field intensity distributions in these two structures are presented in FIG. 4. The shift of the power distribution toward the trapping waveguide can be easily seen. The overlapping coefficient is 93%. The effective refractive indexes are n = 3.3566 and n' = 3.3531, respectively. The variation is Δn = 3.5x10⁻³, a value small enough to avoid strong reflections from the interface 13.

The confinement factor for the initial structure is Γ = 0.72% and for the modified structure is Γ' = 0.42%. The resistance to COD of the radiation amplified in the initial structure and in the modified LAM structure is increased by a factor of ┌ / ┌' = 1.67.

It is worthwhile to compare these results with the results from other layered, initial and modified structures, deriving from the first structures presented in Tables 1 and 2, but having only the activewaveguide, without the trapping waveguide and with substrate cladding layer enlarged enough to avoid strong absorption in the substrate. These structures are presented in tables 3 and 4.

**Table 3. Layer's compositions and thicknesses for a structure with only active waveguide**

| Layer name | Top contact | Top cladd. | 1^{st} w-g top | QW in w-g | 1^{st} w-g bottom | Separation | 2^{nd} w-g. | Substr cladd.. | Substr |
|---|---|---|---|---|---|---|---|---|---|
| | | | 1^{st} waveguide | | | | | | |
| Layer ID | 5 | 6 | 1 | | | | | 7 | 4 |
| Comp. index x | 0.0 | 0.41 | 0.22 | InGaAs | 0.22 | | | 0.32 | 0.0 |
| Thickness(µm) | 0.2 | 1.2 | 0.137 | 0.007 | 0.072 | | | 10 | 100 |

**Table 4. Layer's compositions and thicknesses for a modified structure formed from an initial structure with only active waveguide**

| Layer name | Oxid | Top cladd. | 1^{st} w-g top | QW in w-g | 1^{st} w-g bottom | Separation | 2^{nd} w-g. | Substr cladd. | Substr |
|---|---|---|---|---|---|---|---|---|---|
| | | | 1^{st} waveguide | | | | | | |
| Layer ID | 5 | 6 | 1 | | | | | 7 | 4 |
| Comp. index x | 0.0 | 0.41 | 0.22 | InGaAs | 0.22 | | | 0.32 | 0.0 |
| Thickness (µm) | 0.2 | 0.23 | 0.137 | 0.007 | 0.072 | | | 10 | 100 |

The initial structure having only the active waveguide has a confinement factor r = 0.81 %. The modified structure obtained from the structure with only the active waveguide has a confinement factor ┌' = 0.49%. The resistance to COD of the radiation amplified in the initial structure and in the modified LAM structure is increased by a factor of ┌ / ┌' = 1.65. The effective refractive indexes are n = 3.3505 and n' = 3.3490, respectively, and Δn = 1.5x10⁻³. The coupling constant is 89%. A first disadvantage of structures with only the active waveguide is that the coupling coefficient is lower, such that the diffraction losses offset more what is obtained in COD power level. A second disadvantage is that the substrate cladding layer needs to be very large in order to avoid radiation trapping in substrate and the subsequent losses.

The mirror protection with LAN structures is useful also for the back mirror. If In fact the front and back streets can be obtained in a single process and separated later at the mirror facet formation.

If the top cladding layer removal is done also laterally, a ridge structure is formed. A lateral effective refractive index change is associated with ridge formation. As mentioned, the effective refractive index in initial structure in Table 1 is n = 3.3566, drops to n' = 3.3531 in the modified structure of Table 2 and the variation is Δn = 3.5x10⁻³. A lateral guiding with this value for Δn accepts modes with far field FWHM, FF_{FWHM} = 17 degrees. This is a good value is some cases. In the case of single mode devices operating with high modal gain, a smaller variation Δn might be necessary. To cope with this situation, removal of the top cladding layers down to two depths is needed.

The LAM windows protect the exit facets from the high power density of laser devices. It can work for laser oscillators, but also for Semiconductor Laser Amplifiers (SOA). In this later case the LAM street and the interface 13 should by laterally parallel to the facet 13. The back reflection in the case stripes inclined relative to interface 14 is reduced to very small values by this inclination, but also by small values of Δn.

## Claims

1. An edge emitter diode type laser device made of semiconductor materials with selected optical properties comprising longitudinally, in order:
a first initial segment (12), with an initial layered structure;
a second segment (11), with a modified, less absorbing, layered structure formed between the initial segment (12) and an exit mirror (14);
each layered structure comprising, on a substrate (4), laying transversally, in order:
a substrate cladding layer (9) that transversally confines and contains part of the radiation emitted in an active region (3);
a trapping waveguide layer (2) that captures part of the laser radiation emitted in the active region (3);
a separation layer (10);
a layered trapping waveguide (1) that contains the active region (3);
a top cladding layer (8) that transversally confines and contains part of the radiation emitted in the active region (3),
wherein:
said layered trapping waveguide (1) that contains the active region (3) is situated closer to said top cladding layer (8) than to said substrate cladding layer (9);
layers are constructed to accept only a fundamental transversal mode with same phase in both trapping waveguides;
a part of the top cladding layer (8) of the layered structure of the second segment (11) has been removed so that the remaining part of the top cladding layer (8) of the layered structure of the second segment (11) is thinner than the top cladding layer (8) of the layered structure of the first segment (12);
part of the radiation flux of the fundamental transverse mode propagating in the layered structure of the first segment (12) is transferred to the fundamental transverse mode of the layered structure of the second segment (11), when entering the layered structure of the second segment (11), the overlapping coefficient between the fundamental transversal mode propagating in the initial layered structure of the first segment (12) and the fundamental transversal mode propagating in the layered structure of the second segment(11) having a value close to unity to assure reduced losses for the propagating modes when passing through the separation surface (13); and
the layered structure of the second segment (11) has a confinement factor for the fundamental transverse mode of the active region that is lower than a confinement factor for the fundamental transverse mode of the active region of the initial layered structure of the first segment (12) and part of the radiation propagating in the layered structure of the second segment (11) is shifted from the active region trapping waveguide toward the second trapping waveguide, avoiding absorption losses and nonradiative recombination in the active region close to the mirror facet (14).

2. The edge emitter diode type laser device according to claim 1, **characterised in that**, for a value of the overlapping coefficient between the fundamental mode propagating in the initial layered structure of the first segment (12) and the fundamental transverse mode propagating in the layered structure of the second segment (11) of 93%, the confinement factor of the fundamental transversal mode of the active region of layered structure of the second segment (11) is by a factor of 1/1.67 smaller than the confinement factor for the fundamental transversal mode of the active region in the initial layered structure of the first segment (12).

3. The edge emitter diode type laser device according to claim 1, further comprising laterally two lateral sections that surround the initial layered structure of the first segment (12), **characterised in that** the lateral sections have the layered structure of the layered structure of the second segment (11).

## Patentansprüche

1. Lasereinrichtung vom Typ einer kantenemittierenden Diode, hergestellt aus Halbleitermaterialien mit ausgewählten optischen Eigenschaften, umfassend, longitudinal in der angegebenen Reihenfolge:
ein erstes Initialsegment (12) mit einer initialen Schichtstruktur;
ein zweites Segment (11) mit einer modifizierten, weniger absorbierenden Schichtstruktur, die zwischen dem Initialsegment (12) und einem Austrittsspiegel (14) ausgebildet ist;
wobei jede Schichtstruktur Folgendes auf einem Substrat (4) transversal liegend in der angegebenen Reihenfolge umfasst:
eine Substratmantelschicht (9), die einen Teil der in einem aktiven Bereich (3) emittierten Strahlung transversal einschließt und enthält;
eine Fangstellen-Wellenleiterschicht (2), die einen Teil der in dem aktiven Bereich (3) emittierten Laserstrahlung auffängt;
eine Trennschicht (10);
einen geschichteten Fangstellen-Wellenleiter (1), der den aktiven Bereich (3) enthält;
eine obere Mantelschicht (8), die einen Teil der in dem aktiven Bereich (3) emittierten Strahlung transversal einschließt und enthält,
wobei
der geschichtete Fangstellen-Wellenleiter (1), der den aktiven Bereich (3) enthält, näher an der oberen Mantelschicht (8) als an der Substratmantelschicht (9) angeordnet ist;
Schichten derart konstruiert sind, dass sie nur eine transversale Grundmode mit derselben Phase in beiden Fangstellen-Wellenleitern akzeptieren;
ein Teil der oberen Mantelschicht (8) der Schichtstruktur des zweiten Segments (11) entfernt ist, so dass der verbleibende Teil der oberen Mantelschicht (8) der Schichtstruktur des zweiten Segments (11) dünner als die obere Mantelschicht (8) der Schichtstruktur des ersten Segments (12) ist;
ein Teil des Strahlungsflusses der transversalen Grundmode, die sich in der Schichtstruktur des ersten Segments (12) ausbreitet, beim Eintreten in die Schichtstruktur des zweiten Segments (11) auf die transversale Grundmode der Schichtstruktur des zweiten Segments (11) übertragen wird, wobei der Überlappungskoeffizient zwischen der transversalen Grundmode, die sich in der initialen Schichtstruktur des ersten Segments (12) ausbereitet, und der transversalen Grundmode, die sich in der Schichtstruktur des zweiten Segments (11) ausbreitet, einen Wert nahe eins aufweist, um für reduzierte Verluste für die sich ausbreitenden Moden beim Durchgehen durch die Trennfläche (13) zu sorgen; und
die Schichtstruktur des zweiten Segments (11) einen Einschlussfaktor für die transversale Grundmode des aktiven Bereichs aufweist, der niedriger als ein Einschlussfaktor für die transversale Grundmode des aktiven Bereichs der initialen Schichtstruktur des ersten Segments (12) ist, und ein Teil der sich in der Schichtstruktur des zweiten Segments (11) ausbreitenden Strahlung von dem Fangstellen-Wellenleiter mit der aktiven Region in Richtung des zweiten Fangstellen-Wellenleiters verschoben ist, wodurch Absorptionsverluste und strahlungslose Rekombination in dem aktiven Bereich in der Nähe der Spiegelfacette (14) vermieden werden.

2. Lasereinrichtung vom Typ einer kantenemittierenden Diode nach Anspruch 1, **dadurch gekennzeichnet, dass** für einen Wert des Überlappungskoeffizienten zwischen der Grundmode, die sich in der initialen Schichtstruktur des ersten Segments (12) ausbreitet, und der transversalen Grundmode, die sich in der Schichtstruktur des zweiten Segments (11) ausbreitet, von 93% der Einschlussfaktor der transversalen Grundmode des aktiven Bereichs der Schichtstruktur des zweiten Segments (11) um einen Faktor von 1/1,67 kleiner als der Einschlussfaktor für die transversale Grundmode des aktiven Bereichs in der initialen Schichtstruktur des ersten Segments (12) ist.

3. Lasereinrichtung vom Typ einer kantenemittierenden Diode nach Anspruch 1, ferner umfassend in seitlicher Richtung zwei seitliche Abschnitte, die die initiale Schichtstruktur des ersten Segments (12) umgeben, **dadurch gekennzeichnet, dass** die seitlichen Abschnitte die Schichtstruktur der Schichtstruktur des zweiten Segments (11) aufweisen.

## Revendications

1. Dispositif laser de type diode émettrice marginale composé de matériaux semi-conducteurs ayant des propriétés optiques sélectionnées comprenant longitudinalement dans l'ordre:
un premier segment initial (12) doté d'une structure feuilletée initiale ;
un second segment (11) doté d'une structure feuilletée modifiée moins absorbante formée entre le segment initial (12) et un miroir de sortie (14) ; chaque structure comprenant, sur un substrat (4), reposant transversalement, dans l'ordre:
une couche de revêtement de substrat (9) qui confine transversalement et contient une partie de la radiation émise dans une zone active (3) ;
une couche de guide d'ondes de piégeage (2) qui capture une partie de la radiation laser émise dans la zone active (3) ;
une couche de séparation (10) ;
un guide d'ondes de piégeage plaqué (1) qui contient la zone active (3) ;
une couche de revêtement de dessus (8) qui confine transversalement et contient une partie de la radiation émise dans la zone active (3),
dans lequel :
ledit guide d'ondes de piégeage plaqué (1) qui contient la zone active (3) est situé plus près de ladite couche de revêtement de dessus (8) que de ladite couche de revêtement de substrat (9) ;
les couches sont conçues pour accepter seulement un mode transversal fondamental de même phase dans les deux guides d'ondes de piégeage ;
une partie que la couche de revêtement de dessus (8) de la structure feuilletée du second segment (11) a été enlevée, de sorte que la partie restante de la couche de revêtement de dessus (8) de la structure feuilletée du second segment (11) est plus mince que la couche de revêtement de dessus (8) de la structure feuilletée du premier segment (12) ;
une partie du flux de radiation du mode transversal fondamental se propageant dans la structure feuilletée du premier segment (12) est transférée dans le mode transversal fondamental de la structure feuilletée du second segment (11), en entrant dans la structure feuilletée du second segment (11), le coefficient de recouvrement entre le mode transversal fondamental se propageant dans la structure feuilletée initiale du premier segment (12) et le mode transversal fondamental se propageant dans la structure feuilletée du second segment (11) ayant une valeur proche de l'unité pour assurer des pertes réduites pour les modes en propagation traversant la surface de séparation (13 ; et
la structure feuilletée du second segment (11) a un facteur de confinement pour le mode transversal fondamental de la zone active qui est inférieur à un facteur de confinement pour le mode transversal fondamental de la zone active de la structure feuilletée initiale du premier segment (12) et une partie de la radiation se propageant dans la structure feuilletée du second segment (11) est décalée depuis le guide d'ondes de piégeage de la zone active vers le second guide d'ondes de piégeage en évitant des pertes d'absorption et une recombinaison non radiante dans la zone active à proximité de la facette du miroir (14).

2. Dispositif laser de type diode émettrice marginale selon la revendication 1, **caractérisé en ce que**, pour une valeur du coefficient de recouvrement entre le mode fondamental se propageant dans la structure feuilletée initiale du premier segment (12) et le mode transversal fondamental se propageant dans la structure feuilletée du second segment (11) de 93 %, le facteur de confinement du mode transversal fondamental de la zone active de structure feuilletée du second segment (11) est inférieur à raison d'un facteur 1/1.67 au facteur de confinement pour le mode transversal fondamental de la zone active dans la structure feuilletée initiale du premier segment (12).

3. Dispositif laser de type diode émettrice marginale selon la revendication 1, comprenant en outre latéralement deux sections latérales qui entourent la structure feuilletée initiale du premier segment (12), **caractérisé en ce que** les sections latérales comportent la structure feuilletée de la structure feuilletée du second segment (11).
